# EUROPÄISCHE PATENTSCHRIFT

(11) **EP 2 068 380 B1**
(45) Veröffentlichungstag und Bekanntmachung des Hinweises auf die Patenterteilung: **17.08.2011**
(21) Anmeldenummer: 07020153.8
(22) Anmeldetag: 15.10.2007
(51) Int. Cl.: H01L 51/52

(54) **Organisches elektrolumineszentes Bauelement**
Organic electroluminescent component
Composant électroluminescent organique

(43) Veröffentlichungstag der Anmeldung: 10.06.2009
(73) Patentinhaber: Novaled AG, 01307 Dresden (DE)
(72) Erfinder: Wellmann, Phillip, 64285 Darmstadt (DE); Canzler, Tobias, 01099 Dresden (DE)
(74) Vertreter: Bittner, Thomas L.

(56) Entgegenhaltungen:
- EP-A- 1 388 903
- US-A1- 2004 027 059
- US-A1- 2005 156 197
- TERAI MASAYA ET AL: "Electric-field-assisted bipolar charge generation from internal charge separation zone composed of doped organic bilayer" APPLIED PHYSICS LETTERS, AIP, AMERICAN INSTITUTE OF PHYSICS, MELVILLE, NY, US, Bd. 90, Nr. 8, 21. Februar 2007 (2007-02-21), Seiten 83502-83502, XP012096187 ISSN: 0003-6951

## Beschreibung

Die Erfindung bezieht sich auf ein organisches elektrolumineszentes Bauelement, insbesondere eine organische lichtemittierende Diode.

### Hintergrund der Erfindung

Eine Basisstruktur für eine organische lichtemittierende Diode (OLED) wurde von Tang et al. (Appl. Phys. Lett. 51, Seite 913 ff., 1987) angegeben. Heutige Strukturen für organische lichtemittierende Dioden basieren im wesentlichen stets auf dem gleichen Prinzip. Auf einem Substrat ist ein Stapel von Schichten gebildet, bei dem zwischen einer Elektrode und einer Gegenelektrode eine Schichtanordnung mit organischen Schichten gebildet ist, welche üblicherweise eine Gesamtdicke von etwa 100nm aufweist. Mit der Elektrode und der Gegenelektrode sind eine Anode und eine Kathode gebildet, die zum Betrieb der organischen lichtemittierenden Diode mit einer elektrischen Spannung beaufschlagt werden können, wodurch das Bauelement Licht abgibt. Benachbart zur Anode ist in der Schichtanordnung üblicherweise eine sogenannte Löchertransportschicht aus einem organischen Material angeordnet. Benachbart zur Kathode wird eine sogenannte Elektronentransportschicht aus einem organischen Material hergestellt. Die beim Anlegen einer elektrischen Spannung in die Schichtanordnung injizierten Ladungsträger, nämlich Elektronen und Löcher, werden zu einem lichtemittierenden Bereich, welcher ebenfalls als Schicht gebildet ist, transportiert und rekombinieren dort unter Abgabe von Licht.

Um das organische lichtemittierende Bauelement zum Leuchten zu bringen, wird beim Betrieb üblicherweise eine Gleichspannung angelegt. Derartige Bauelemente, die mit Gleichspannung betrieben werden, weisen bestimmte Limitierungen auf. In solchen organischen lichtemittierenden Dioden werden die Ladungsträger beim Anlegen der elektrischen Spannung an die Elektroden in die Anordnung organischer Schichten, die beispielsweise als ein organischer Film gebildet ist, injiziert. Um eine gute Injektion von Elektronen und Löchern aus den Elektroden zu gewährleisten, sind spezielle Elektrodenmaterialien notwendig. Eine gute Injektion bedeutet, dass im Bereich des Übergangs zwischen Elektrode und organischer Schichtanordnung nur ein kleiner Spannungsabfall auftritt. Es kann eine Behandlung der Elektroden mit einem Sauerstoffplasma oder eine UV-Ozon-Behandlung vorgesehen sein, was üblicherweise bei einer Grundelektrode aus ITO (Indiumzinnoxid) Vorteile bringt.

In organischen lichtemittierenden Dioden, die mit Gleichspannung betrieben werden, wird das elektrische Feld stets in der gleichen Richtung ausgebildet, um Elektrolumineszenz zu erzeugen. Dieses hat zur Folge, dass auf alle Ladungsträger in dem elektrischen Feld eine stationäre Kraft wirkt. Die stets gleichgerichteten Kräfte führen unter Umständen zur Migration von Teilchen oder Partikeln, insbesondere wenn diese elektrisch geladen sind, in der Schichtanordnung aus organischem Material, was die Lebensdauer des Bauelementes beschränkt.

Organische lichtemittierende Dioden sind sogenannte Oberflächenemitter, bei denen wenigstens eine der Elektroden (semi)transparent ist, um das in der Schichtanordnung aus organischem Material erzeugte Licht auszukoppeln. Deshalb ist wenigstens die (semi)transparente Elektrode üblicherweise als sehr dünne Schicht gebildet. Diese Elektrode weist für den Stromfluss beim Betrieb des Bauelementes einen kleinen Querschnitt auf, wodurch Verluste entstehen. Diese Widerstandsverluste in der Elektrode werden bei großflächigen Bauelementen bedeutend, beispielsweise Anzeigebildschirmen oder flächigen Leuchtmitteln.

Als eine Bauart organischer lichtemittierender Bauelemente zum Gleichspannungsbetrieb sind weiterhin gestapelte Architekturen bekannt, bei denen mehrere organische lichtemittierende Dioden übereinander gestapelt und elektrisch verbunden sind (EP 1 804 308, EP 1 804 309). Die Stapelarchitektur verfügt gegenüber einzelnen organischen lichtemittierenden Dioden über wenigstens zwei Vorteile. Das Stapeln mehrerer organischer lichtemittierender Dioden bedeutet zunächst eine entsprechende Vervielfachung der Lichtmenge. Darüber hinaus kann die Betriebsstabilität erhöht werden, wenn die gestapelten organischen lichtemittierenden Dioden mit einer geringeren Betriebsspannung betrieben werden, wobei immer noch die Lichtmenge einer Einzeldiode erreichbar ist.

In gestapelten Architekturen organischer lichtemittierender Bauelemente, die mit Gleichspannung betrieben werden, sind die einzelnen Einheiten üblicherweise mittels verschiedener inorganischer Materialien elektrisch verbunden, die als eine Ladungsträger-Erzeugungsschicht dienen (vgl. Canzler et al., Proc. of SPIE, Vol. 6333, Seite 11 ff., 2006; Gu et al., J. Appl. Phys. 86, Seite 4076 ff., 1999; Matsumoto et al., SID 03 Digest, Seite 979 ff, 2003; Kanno et al., Adv. Mat. 18, Seite 339 ff., 2006; Sun et al., Appl. Phys. Lett. 87, Seite 093504 ff., 2005).

Darüber hinaus wurden gestapelte Architekturen vorgeschlagen, in denen zwischen zwei übereinander gestapelten organischen lichtemittierenden Dioden ein pn-Übergang angeordnet ist, bei dem eine n-dotierte Schicht unter Verwendung eines Alkalimetalls und eine p-dotierte Schicht unter Verwendung von FeCl₃ gebildet sind (Liao et al., Appl. Phys. Lett. 84, Seite 167 ff., 2004). Darüber hinaus wurde für gestapelte Bauelemente zum Betrieb mit Gleichspannung eine molekulare Dotierung vorgeschlagen (Canzler et al., Proc. of SPIE Vol. 6333, Seite 11 ff., 2006). Charakteristisch für die Herstellung p- oder n-dotierter organischer Schichten mittels molekularer Dotierung ist das gemeinsame Abscheiden eines Matrixmaterials und eines zugeordneten Dotierungsmaterials zum Ausbilden der dotierten Schicht, wobei bei der Schichtherstellung zwischen dem Matrixmaterial und dem Dotierungsmaterial ein Ladungstransfer stattfindet, wodurch eine dotierte Schicht mit verbesserter elektrischer Leitfähigkeit für die Ladungsträger entsteht.

Es sind weiterhin organische lichtemittierende Bauelemente, insbesondere organische lichtemittierende Dioden, bekannt, welche mit einer Wechselspannung betrieben werden, die an die Elektroden angelegt wird. Die zum Wechselspannungsbetrieb vorgesehenen Bauelementen basieren auf einem grundsätzlich anderen Aufbau, weshalb sich andere Anforderungen und Erfordernisse für den konstruktiven Aufbau ergeben. Im Unterschied zu den mit Gleichspannung zu betreibenden organischen lichtemittierenden Bauelementen ist bei den mit Wechselspannung betriebenen organischen lichtemittierenden Bauelementen die Schichtanordnung aus organischem Material, welche zwischen den Elektroden angeordnet ist, von den beiden Elektroden elektrisch isoliert. Es soll und kann keine Injektion von Ladungsträgern aus den Elektroden in die Schichtanordnung stattfinden. Vielmehr werden die Ladungsträger in der Schichtanordnung selbst erzeugt, wenn eine elektrische Wechselspannung an die Elektroden angelegt wird.

Aus dem Dokument US 2004/0027059 A1 ist ein organisches elektrolumineszentes Bauelement bekannt für einen Betrieb mit Wechselspannung. Bei dem bekannten Bauelement ist in der zwischen den Elektroden gebildeten Schichtanordnung zwischen benachbarten lichtemittierenden Schichten jeweils eine bipolare Ladungsträger-Erzeugungsschicht angeordnet, in welcher die Ladungsträger, nämlich Elektronen und Löcher, beim Anlegen der Wechselspannung erzeugt werden. Aus der bipolaren Ladungsträger-Erzeugungsschicht treten die erzeugten Ladungsträger dann in die benachbarten lichtemittierenden Schichten ein, um dort unter Lichtabgabe zu rekombinieren. Ein ähnlicher Aufbau ist in Tsutsui et al. (Appl. Phys. Lett. 85, Nr. 12, Seiten 2382 ff., 2004) bekannt. Die bipolare Ladungsträger-Erzeugungsschicht kann ein- oder mehrschichtig aufgebaut sein.

Aus dem Dokument US 2005/0156197 A1 sind organische Halbleiterelemente für den Gleichspannungsbetrieb bekannt, bei denen in einer Ausführungsform ein Ladungsträger-Erzeugungsbereich mit einem pn-Schichtübergang zwischen einer Schicht aus einem organischen Akzeptormaterial und einer Schicht aus einem organischen Donormaterial gebildet ist.

Ein bipolarer Ladungsträger-Erzeugungsbereich ist weiterhin aus Terai et al. ("Electric-fieldassisted bipolar charge generation from internal charge separation zone composed of doped organic bilayer", Appl. Phys. Lett., Bd. 90, Nr. 8, 21. Februar 2007, Seiten 83502-83502) bekannt.

### Zusammenfassung der Erfindung

Aufgabe der Erfindung ist es, ein organisches elektrolumineszentes Bauelement anzugeben, bei dem eine erweiterte Gestaltungsfreiheit hinsichtlich des strukturellen Schichtaufbaus ermöglicht ist.

Diese Aufgabe wird erfindungsgemäß durch ein organisches elektrolumineszentes Bauelement nach dem unabhängigen Anspruch 1 gelöst. Vorteilhafte Ausgestaltungen der Erfindung sind Gegenstand von abhängigen Unteransprüchen.

Die Erfindung umfasst den Gedanken eines organischen elektrolumineszenten Bauelementes, bei dem zwischen einer Elektrode und einer Gegenelektrode eine von der Elektrode und der Gegenelektrode elektrisch isolierte, organische Schichtanordnung gebildet ist und von der Schichtanordnung eine lichtemittierende Schicht und ein der lichtemittierenden Schicht zugeordneter Ladungsträger-Erzeugungsbereich umfasst sind, wobei der Ladungsträger-Erzeugungsbereich konfiguriert ist, beim Anlegen einer elektrischen Wechselspannung an die Elektrode und die Gegenelektrode positive und negative elektrische Ladungsträger bereitzustellen, und wobei in dem Ladungsträger-Erzeugungsbereich mittels einer p-dotierten organischen Schicht und einer n-dotierten organischen Schicht, die benachbart zu der p-dotierten organischen Schicht angeordnet ist, ein pn-Schichtübergang gebildet ist. Mit Hilfe des Vorsehens eines pn-Schichtüberganges in dem Ladungsträger-Erzeugungsbereich ist eine flexibel die Schichtdicke der n-dotierten organischen Schicht und der p-dotierten organischen Schicht variabel eingestellt werden können, ohne hierbei die Betriebsspannung und -frequenz des Bauteils stark zu erhöhen. Mit elektrisch undotierten Schichten, wie sie im Stand der Technik gebildet sind, ist dies gar nicht oder nur sehr begrenzt möglich, weil in diesem Fall eine Erhöhung der Schichtdicke den elektrischen Widerstand des Bauelementes erhöht und zu einer Erhöhung der benötigten Betriebsspannung führt.

Eine bevorzugte Weiterbildung der Erfindung sieht vor, dass die Schichtanordnung von der Elektrode und der Gegenelektrode mittels einer jeweiligen Isolierschicht elektrisch isoliert ist. Die jeweilige Isolierschicht kann hierbei in einer Ausgestaltung direkt auf der zugeordneten Elektrode gebildet sein, nämlich auf der der Schichtanordnung zugewandten Elektrodenfläche.

Bei einer zweckmäßigen Ausgestaltung der Erfindung kann vorgesehen sein, dass der Ladungsträger-Erzeugungsbereich in Kontakt mit einer der Isolierschichten gebildet ist.

Eine vorteilhafte Ausführungsform der Erfindung sieht vor, dass die lichtemittierende Schicht in Kontakt mit einer der Isolierschichten gebildet ist.

Bevorzugt sieht eine Fortbildung der Erfindung vor, dass in dem Ladungsträger-Erzeugungsbereich ein weiterer pn-Schichtübergang gebildet ist, indem:
- der Ladungsträger-Erzeugungsbereich als eine organische npn-Schichtstruktur gebildet ist, bei der benachbart zu der p-dotierten organischen Schicht eine weitere n-dotierte organische Schicht angeordnet ist, oder
- der Ladungsträger-Erzeugungsbereich als eine organische pnp-Schichtstruktur gebildet ist, bei der benachbart zu der n-dotierten organischen Schicht eine weitere p-dotierte organische Schicht angeordnet ist.

Bei einer vorteilhaften Ausgestaltung der Erfindung kann vorgesehen sein, dass zwischen der lichtemittierenden Schicht und dem Ladungsträger-Erzeugungsbereich eine Zwischenschicht mit bipolaren Ladungsträger-Transporteigenschaften angeordnet ist. Die Ausbildung bipolarer Ladungsträger-Transportschichten bedeutet hierbei, dass sowohl die positiven elektrischen Ladungsträger (Löcher) als auch die negativen elektrischen Ladungsträger (Elektronen) in der und durch die Zwischenschicht transportiert werden können, um sie aus dem Ladungsträger-Erzeugungsbereich zu der lichtemittierenden Schicht zu überführen.

Eine Weiterbildung der Erfindung kann vorsehen, dass die lichtemittierende Schicht in Kontakt mit dem Ladungsträger-Erzeugungsbereich gebildet ist.

Eine bevorzugte Weiterbildung der Erfindung sieht vor, dass zwischen der lichtemittierenden Schicht und dem Ladungsträger-Erzeugungsbereich eine Zwischenschicht mit bipolaren Transporteigenschaften für die positiven und die negativen elektrischen Ladungsträger angeordnet ist. Mittels der bipolaren Transporteigenschaften wird der Transport der positiven und der negativen elektrischen Ladungsträger in die lichtemittierende Schicht ermöglicht, wohingegen ein Transport von Ladungsträgern aus der lichtemittierenden Schicht heraus blockiert wird. Hierfür sind am Ladungsträgertransport beteiligte Energieniveaus für Elektronen und Löcher der Zwischenschicht an effektive am Ladungsträgertransport beteiligte Energieniveaus der lichtemittierenden Schicht angepasst, so dass sowohl für Löcher als auch für Elektronen eine energetische Stufe vorliegt, die im normalen Betrieb des Bauelementes einen Rücktransfer der Ladungsträger aus der lichtemittierenden Schicht in die Zwischenschicht verhindert. Die energetische Stufe ist zweckmäßig mindestens so groß wie die thermische Energie der Ladungsträger bei Betriebstemperatur. Bei Raumtemperatur (23°C) zum Beispiel beträgt kT etwa 25meV.

Bei einer zweckmäßigen Ausgestaltung der Erfindung kann vorgesehen sein, dass die lichtemittierende Schicht mit mehreren lichtemittierenden Teilschichten gebildet ist.

Eine vorteilhafte Ausführungsform der Erfindung sieht wenigstens eine weitere lichtemittierende Schicht vor. Die wenigstens eine weitere lichtemittierende Schicht kann in gleicher Weise wie die lichtemittierende Schicht oder verschieden hiervon ausgebildet sein. Dieses gilt sowohl für einen strukturellen Aufbau der wenigstens einen weiteren lichtemittierenden Schicht als auch die Ausgestaltung der zu ihr benachbarten Bereiche in der Schichtanordnung. Die wenigstens eine weitere lichtemittierende Schicht kann die in ihr zur Lichterzeugung rekombinierenden Ladungsträger aus dem gleichen Ladungsträger-Erzeugungsbereich empfangen, aus welchem die Ladungsträger in die lichtemittierende Schicht gelangen, oder aus einem anderen Ladungsträger-Erzeugungsbereich.

Bevorzugt sieht eine Fortbildung der Erfindung vor, dass die lichtemittierende Schicht und die wenigstens eine weitere lichtemittierende Schicht benachbart und durch eine bipolare Trennschicht getrennt gebildet sind, die konfiguriert ist, einen Transport der positiven und der negativen elektrischen Ladungsträgern durch die bipolare Trennschicht hindurch zu blockieren. Auf diese Weise wird ein Übertreten von elektrischen Ladungsträgern zwischen der lichtemittierenden Schicht und die wenigstens einen weiteren lichtemittierenden Schicht unterbunden. Alternativ hierzu können die lichtemittierende Schicht und die wenigstens eine weitere lichtemittierende Schicht in Kontakt miteinander gebildet sein.

Bei einer vorteilhaften Ausgestaltung der Erfindung kann vorgesehen sein, dass der Ladungsträger-Erzeugungsbereich zwischen der lichtemittierenden Schicht und wenigstens einer weiteren lichtemittierenden Schicht angeordnet sind.

Eine Weiterbildung der Erfindung kann vorsehen, dass die lichtemittierende Schicht ein Emittersystem und die wenigstens eine weitere lichtemittierende Schicht ein weiteres Emittersystem umfassen, wobei das Emittersystem und das weitere Emittersystem konfiguriert sind, Licht unterschiedlicher Farbe abzugeben.

Eine bevorzugte Weiterbildung der Erfindung sieht wenigstens einen weiteren Ladungsträger-Erzeugungsbereich vor. Der wenigstens eine weitere Ladungsträger-Erzeugungsbereich kann in gleicher Weise wie der Ladungsträger-Erzeugungsbereich oder verschieden hiervon gebildet sein. Dieses gilt sowohl für die strukturelle oder materielle Ausführung als auch die Gestaltung der zu dem wenigstens einen weiteren Ladungsträger-Erzeugungsbereich benachbarten Schichten in der Schichtanordnung. In einer Ausgestaltung weisen der Ladungsträger-Erzeugungsbereich und der wenigstens eine weitere Ladungsträger-Erzeugungsbereich in Blickrichtung von der Elektrode zu der Gegenelektrode einen umgekehrten Schichtaufbau auf, so dass ein pn-Schichtübergang und ein np-Schichtübergang in Blickrichtung gebildet sind.

Bei einer zweckmäßigen Ausgestaltung der Erfindung kann vorgesehen sein, dass die lichtemittierende Schicht zwischen dem Ladungsträger-Erzeugungsbereich und dem wenigstens einen weiteren Ladungsträger-Erzeugungsbereich angeordnet ist.

Eine vorteilhafte Ausführungsform der Erfindung sieht vor, dass in der Schichtanordnung mehrere lichtemittierende Schichten und mehrere Ladungsträger-Erzeugungsbereiche alternierend angeordnet sind.

Bevorzugt sieht eine Fortbildung der Erfindung vor, dass die Schichtanordnung wenigstens eine Ladungsträger-Blockschicht aufweist, die konfiguriert ist, einen Transport wenigstens der positiven elektrischen Ladungsträger oder wenigstens der negativen elektrischen Ladungsträger zu blockieren.

Eine zweckmäßige Ausgestaltung der Erfindung sieht vor, dass die Schichtanordnung zwischen der Elektrode und der Gegenelektrode mit einer nicht symmetrischen Anordnung der Schichten gebildet ist. Eine nicht symmetrische Schichtanordnung ist dann zwischen der Elektrode und der Gegenelektrode gebildet, wenn sich bei Umkehr der organischen Schichtanordnung eine andere Schichtreihenfolge bei gleicher Betrachtungsweise ergibt, also beispielsweise von der Elektrode zur Gegenelektrode. Für eine asymmetrische Ausführung kann mittels Anlegen einer nicht symmetrischen Wechselspannung die Balance der positiven und der negativen elektrischen Ladungsträger verändert werden. Eine asymmetrische Wechselspannung ist dadurch charakterisiert, dass die zeitliche Länge für positive und negative Signalanteile verschieden ist und / oder asymmetrische Amplituden für die beiden Signalanteile vorliegen, d.h. der Wechselspannung wird eine Gleichspannung überlagert. Hierdurch kann mittels extern steuerbarer Parameter die Leistungseffizienz des elektrolumineszenten Bauteils optimiert werden.

Für nicht symmetrische Ausführungen mit mehreren lichtemittierenden Schichten kann zusätzlich auch die Balance von Lichtemissionsanteilen, die beispielsweise zur Ermittlung spektraler Anteile mittels wellenlängenabhängig aufgelöster Messungen oder Intensitätsmessungen ermittelbar sind, der verschiedenen lichtemittierenden Schichten eingestellt werden. Das ist beispielsweise für eine Weißlichterzeugung mittels einer blauen lichtemittierenden Schicht und einer gelben lichtemittierenden Schicht vorteilhaft, da so ein Weißlichtpunkt mittels eines externen Parameters, nämlich der überlagerten Gleichspannung, geregelt werden kann.

### Beschreibung bevorzugter Ausführungsbeispiele der Erfindung

Die Erfindung wird im folgenden anhand von Ausführungsbeispielen unter Bezugnahme auf Figuren einer Zeichnung näher erläutert. Hierbei zeigen:
- Fig. 1: eine schematische Darstellung eines organischen elektrolumineszenten Bauelementes in einer symmetrischen Ausführung zum Betrieb mit Wechselspannung,
- Fig. 2: eine graphische Darstellung der Leuchtdichte in Abhängigkeit von der Frequenz einer angelegten Wechselspannung für das organische elektrolumineszente Bauelement nach Fig. 1,
- Fig. 3A bis 3D: eine schematische Darstellung eines organischen elektrolumineszenten Bauelementes zum Betrieb mit Wechselspannung, bei dem zwischen zwei Ladungsträger-Erzeugungsbereichen eine lichtemittierende Schicht gebildet ist,
- Fig. 4A bis 4D: eine schematische Darstellung eines organischen elektrolumineszenten Bauelementes zum Betrieb mit Wechselspannung, bei dem im Unterschied zu dem Bauelement nach den Fig. 3A bis 3D die lichtemittierende Schicht zweischichtig gebildet ist,
- Fig. 5A bis 5D: eine schematische Darstellung eines organischen elektrolumineszenten Bauelementes zum Betrieb mit Wechselspannung mit mehreren lichtemittierenden Schichten und mehreren Ladungsträger-Erzeugungsbereichen,
- Fig. 6A bis 6D: eine schematische Darstellung eines organischen elektrolumineszenten Bauelementes in einer symmetrischen Ausführung zum Betrieb mit Wechselspannung, bei dem die lichtemittierende Schicht von Zwischenschichten umgeben ist,
- Fig. 7A bis 7D: eine schematische Darstellung eines organischen elektrolumineszenten Bauelementes zum Betrieb mit Wechselspannung, bei dem zwei lichtemittierende Schichten mittels einer bipolaren Trennschicht getrennt sind,
- Fig. 8A bis 8D: eine schematische Darstellung eines organischen elektrolumineszenten Bauelementes zum Betrieb mit Wechselspannung, bei dem ein Ladungsträger-Erzeugungsbereich zwischen zwei lichtemittierenden Schichten angeordnet ist,
- Fig. 9A bis 9D: eine schematische Darstellung eines organischen elektrolumineszenten Bauelementes zum Betrieb mit Wechselspannung, bei dem ein Ladungsträger- Erzeugungsbereich mit einer npn-Schichtstruktur und ein weiterer Ladungsträger-Erzeugungsbereich mit einer pnp-Schichtstruktur vorgesehen sind,
- Fig. 10: eine verallgemeinerte schematische Darstellung eines organischen elektrolumineszenten Bauelementes zum Betrieb mit Wechselspannung in einer nicht symmetrischen Ausführung,
- Fig. 11: eine graphische Darstellung eines Lumineszenzspektrums für ein blaues und ein gelbes Emittersystem,
- Fig. 12: graphische Darstellungen für eine symmetrische Wechselspannung und ein Elektrolumineszenzspektrum für das Bauelement aus Fig. 10,
- Fig. 13: graphische Darstellungen für eine nicht symmetrische Wechselspannung und ein sich hieraus ergebendes Elektrolumineszenzspektrum für das Bauelement nach Fig. 10, und
- Fig. 14: graphische Darstellungen für eine nicht symmetrische Wechselspannung und ein sich hieraus ergebendes Elektrolumineszenzspektrum für das Bauelement nach Fig. 10.

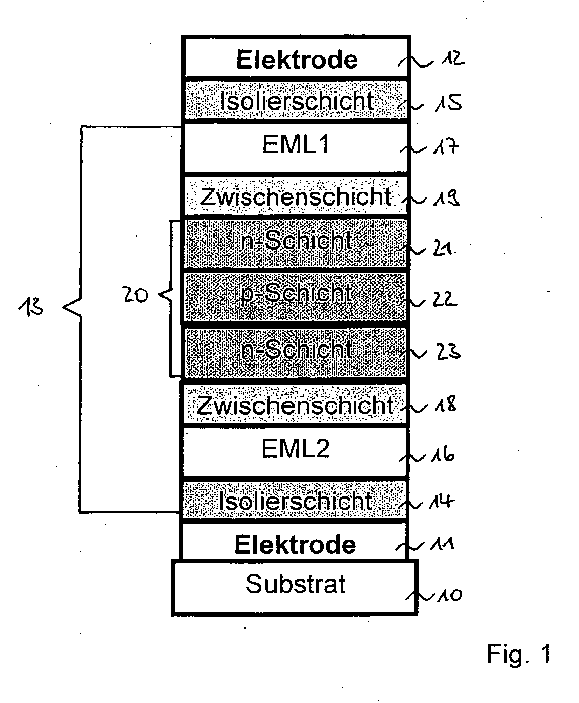

Fig. 1 zeigt eine schematische Darstellung eines organischen elektrolumineszenten Bauelementes zum Betrieb mit Wechselspannung, bei dem auf einem Substrat 10 mehrere Schichten aufgebracht sind, nämlich eine als Grundelektrode ausgeführte Elektrode 11, eine als Deckelektrode ausgeführte Gegenelektrode 12, eine Schichtanordnung 13 aus einem oder mehreren organischen Materialien, die von den beiden Elektroden 11, 12 durch eine Isolierschicht 14 sowie eine weitere Isolierschicht 15 elektrisch isoliert ist. Die Schichtanordnung 13 ist eine Anordnung organischer Schichten, welche eine lichtemittierende Schicht (EML2) 16 sowie eine weitere lichtemittierende Schicht (EML1) 17 umfasst. In den lichtemittierenden Schichten 16, 17 rekombinieren positive elektrische Ladungsträger (Löcher) und negative elektrische Ladungsträger (Elektronen) beim Betrieb des Bauelementes unter Abgabe von Licht.

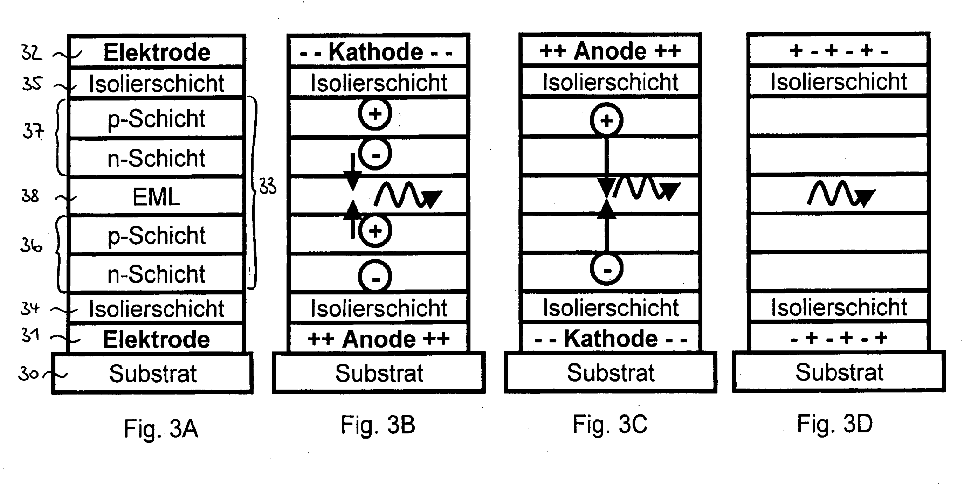

Benachbart zu den lichtemittierenden Schichten 16, 17 sind eine Zwischenschicht 18 sowie eine weitere Zwischenschicht 19 gebildet. Die Zwischenschichten 18, 19 erlauben den Transport der elektrischen Ladungsträger in die lichtemittierenden Schichten 16, 17 und blockieren den entgegengesetzten Ladungsträgertransport aus den lichtemittierenden Schichten 16, 17 heraus. In die Zwischenschichten 18, 19 eingebettet ist ein Ladungsträger-Erzeugungsbereich 20 mit einer n-dotierten organischen Schicht (n-Schicht) 21, einer p-dotierten organischen Schicht (p-Schicht) 22 und einer weiteren n-dotierten organischen Schicht (n-Schicht) 23. Die dotierten Schichten 21, 22, 23 sind jeweils aus einem System mit einem Matrixmaterial und einem eingelagerten Dotierungsmaterial hergestellt, wodurch eine molekulare elektrische Dotierung gebildet ist. Die Materialien sind mittels gemeinsamer Verdampfung abgeschieden, so dass Moleküle des Dotierungsmaterials räumlich verteilt in das Matrixmaterial eingelagert oder eingebettet sind. Bei der Herstellung der dotierten Schichten 21, 22, 23 findet ein Ladungstransfer zwischen dem jeweiligen Matrixmaterial und dem zugehörigen Dotierungsmaterial statt, so dass die jeweils gewünschte molekulare Dotierung entsteht, welche eine verbesserte elektrische Leitfähigkeit für gewünschte Ladungsträger zur Folge hat. Der Ladungstransfer beruht auf einer Redoxreaktion zwischen Matrixmaterial und Dotierungsmaterial. Ergebnis ist eine Erhöhung der Anzahl freier Ladungsträger in der dotierten Schicht im Vergleich zu einer Schicht, die nur aus dem Matrixmaterial besteht. Art und Herstellung derart dotierter Schichten sind im Übrigen in verschiedenen Ausführungen als solche bekannt und werden hier deshalb nicht weiter erläutert. Die zur Dotierung gemachten Erläuterungen geltend entsprechend für die Ausführungsbeispiele in den Fig. 3 bis 9 unten.

In den folgenden Ausführungen werden die nachfolgend genannten Abkürzungen verwendet:
ITO = Indium-Zinn-Oxid; A1 = Aluminium; CBP = 4,4'-bis(carbazol-9-yl)biphenyl; BAlq = Bis(2-methyl-8-quinolinato)-4-(phenylphenolato)aluminium-(III); MeOTPD = N,N,N',N'-tetrakis(4-methoxyphenyl)benzidine; F4-TCNQ = 7,7,8,8-Tetracyano-2,3,5,6-tetrafluoroquinodimethane; Cs = Cäsium; BPhen = 4,7-diphenyl-1,10-phenanthroline; Rubren = 5,6,11,12-Tetraphenylnaphthacene; Alq3 = Tris (8-hydroxyquinoline) aluminum; und DCJTB = 4-(Dicyanomethylene)-2-tert-butyl-6-(1,1,7,7-tetramethyljulolidin-4-yl-vinyl)-4H-pyran.

In einer Ausführungsform wurde das organische elektrolumineszente Bauelement in Fig. 1 mit folgendem Schichtaufbau hergestellt: Grundelektrode (ITO, Schichtdicke = 90nm), Isolierschicht (CBP, 40nm), lichtemittierende Schicht (Rubren mit Alq₃, (38 w%) und DCJTB (2 w%, 20nm), Zwischenschicht (BAlq₂, 10nm), weitere n-dotierte organische Schicht (BPhen mit Cs, 10nm), p-dotierte organische Schicht (MeOTPD mit F4-TCNQ, 20nm), weitere n-dotierte organische Schicht (BPhen mit Cs, 10nm), weitere Zwischenschicht (BAlq₂, 10nm), weitere lichtemittierende Schicht (Rubren mit Alq₃ (38w%) und DCJTB (2w%, 20nm)), weitere Isolierschicht (CBP, 40nm) und Deckelektrode (Al, 100nm).

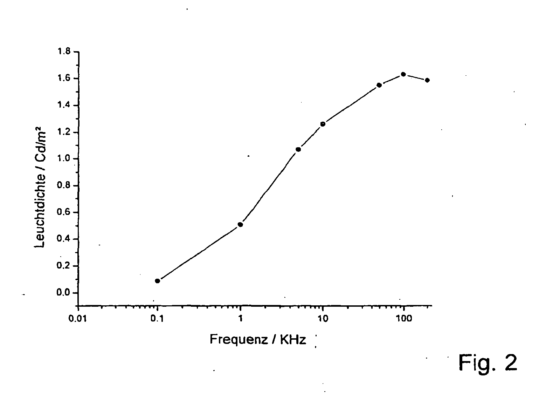

Fig. 2 zeigt eine graphische Darstellung von Messwerten für die Leuchtdichte des vorgenannten organischen elektrolumineszenten Bauelementes in Abhängigkeit von der Frequenz der angelegten Wechselspannung. Die Wechselspannung hat eine Amplitude von ±20V. Demgegenüber zeigt das Bauteil keine Elektrolumineszenz für eine angelegte Gleichspannung von +20V oder -20V, eine Wechselspannung mit nur positiven Spannungswerten, beispielsweise zwischen 0 und +20V, und eine Wechselspannung mit nur negativen Spannungswerten, beispielsweise zwischen 0 und +20V.

Fig. 3A bis 3D zeigen eine schematische Darstellung eines organischen elektrolumineszenten Bauelementes zum Betrieb mit Wechselspannung, bei dem zwischen zwei Ladungsträger-Erzeugungsbereichen eine lichtemittierende Schicht gebildet ist.

Gemäß Fig. 3A sind auf einem Substrat 30 eine als Grundelektrode ausgeführte Elektrode 31 sowie eine als Deckelektrode ausgeführte Elektrode 32 gebildet. Zwischen den Elektroden 31, 32 ist eine organische Schichtanordnung 33 hergestellt, die mit Hilfe von Isolierschichten 34, 35 von den Elektroden 31, 32 elektrisch isoliert ist. Die organische Schichtanordnung 33 umfasst zwei Ladungsträger-Erzeugungsbereiche 36, 37, welche zur Ausbildung eines pn-Schichtübergangs jeweils eine organische p-dotierte und eine organische n-dotierte Schicht (p- bzw. n-Schicht) aufweisen, zwischen denen eine lichtemittierende Schicht (EML) 38 angeordnet ist.

Die Fig. 3B bis 3D dienen der schematischen Erläuterung des Betriebs des organischen elektrolumineszenten Bauelementes aus Fig. 3A. Beim Anlegen einer elektrischen Wechselspannung kommt es zur abwechselnden Ausbildung einer Anode und einer Kathode mittels der beiden Elektroden 31, 32 (vgl. Fig. 3B und 3C). Je nach Ausbildung von Kathode oder Anode werden in den Ladungsträger-Erzeugungsbereichen 34, 35 Ladungsträger in Form von Löchern und Elektronen erzeugt, die anschließend in die lichtemittierende Schicht 38 wandern und dort unter Lichtabgabe rekombinieren.

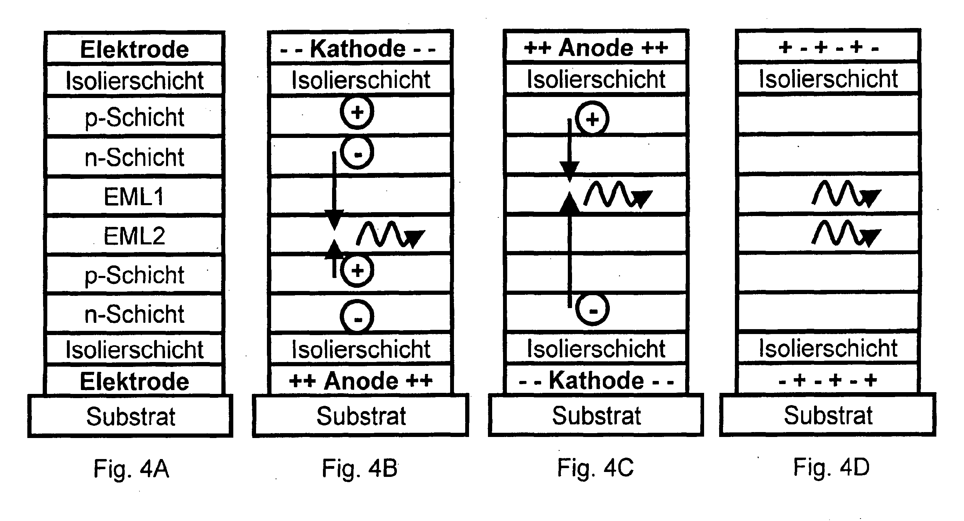

Fig. 4A bis 4D zeigen eine schematische Darstellung eines organischen elektrolumineszenten Bauelementes zum Betrieb mit Wechselspannung, bei dem im Unterschied zu dem Bauelement nach den Fig. 3A bis 3D die lichtemittierende Schicht zweischichtig gebildet ist. Die Fig. 4B bis 4D zeigen wieder schematisch den Betrieb des organischen elektrolumineszenten Bauelementes aus Fig. 4A beim Anlegen einer elektrischen Wechselspannung. Bei dieser Ausführung kann das Verhältnis von jeweiligen Lichtemissionsanteilen, die beispielsweise anhand einer abgegebenen Lichtintensität ermittelt werden können, für die lichtemittierenden Schichten mittels einer nicht symmetrischen Wechselspannung eingestellt werden. Bei Ausführung der lichtemittierenden Schichten aus unterschiedlichen Materialien, die zu unterschiedlichen Emissionsspektren führen, kann so das Gesamtemissionsspektrum des elektrolumineszenten Bauteils variabel eingestellt werden. Eine unterschiedliche Ausgestaltung wird insbesondere dadurch erreicht, dass in ein wahlweise gleichartiges Matrixmaterial unterschiedliche Emittermaterialien eingelagert werden. Eine derartige Ausführung, einschließlich der hiermit verbundenen Betriebsmöglichkeiten, kann auch in Verbindung mit anderen der erläuterten Ausführungsformen genutzt werden, insbesondere zur variablen Weißlichterzeugung.

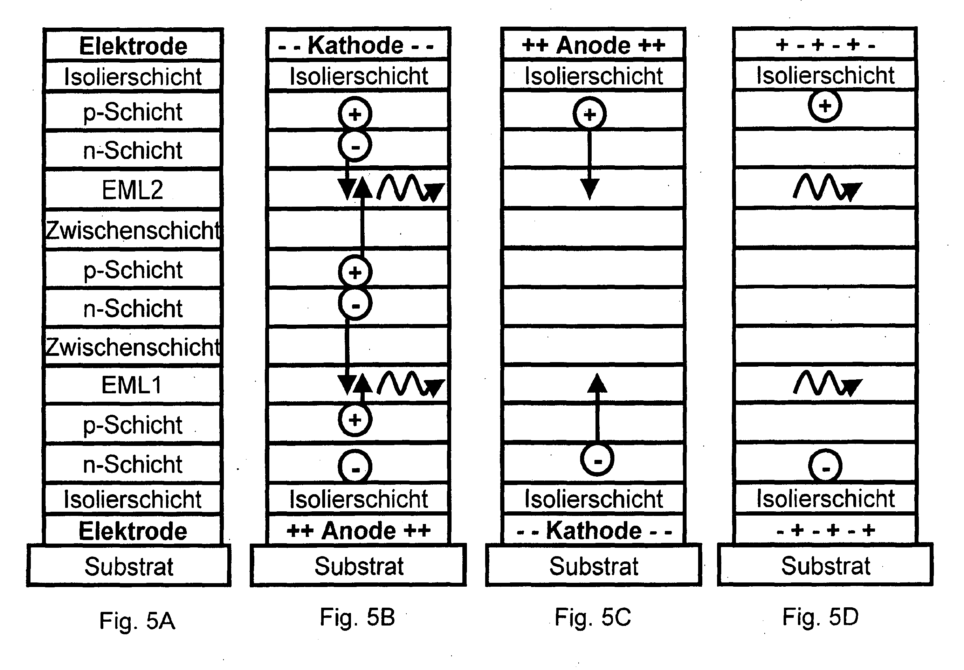

Fig. 5A bis 5D zeigen eine schematische Darstellung eines organischen elektrolumineszenten Bauelementes zum Betrieb mit Wechselspannung mit mehreren lichtemittierenden Schichten und mehreren Ladungsträger-Erzeugungsbereichen. Fig. 5B bis 5D zeigen schematisch den Betrieb des organischen elektrolumineszenten Bauelementes aus Fig. 5A beim Anlegen einer elektrischen Wechselspannung.

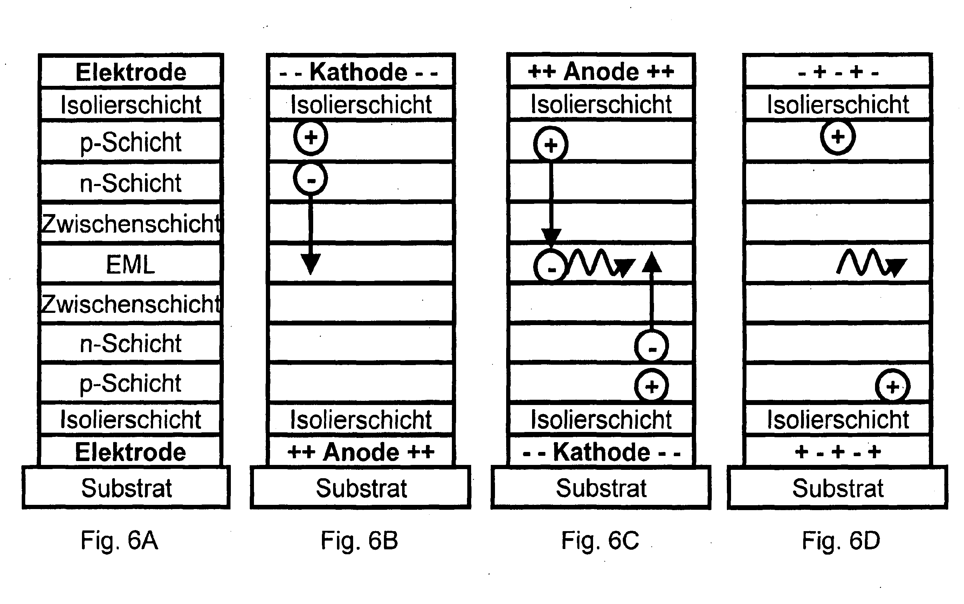

Fig. 6A bis 6D zeigen eine schematische Darstellung eines organischen elektrolumineszenten Bauelementes zum Betrieb mit Wechselspannung, bei die lichtemittierende Schicht von Zwischenschichten 60, 61 umgeben ist. Fig. 6B bis 6D zeigen schematisch den Betrieb des organischen elektrolumineszenten Bauelementes aus Fig. 6A beim Anlegen einer elektrischen Wechselspannung.

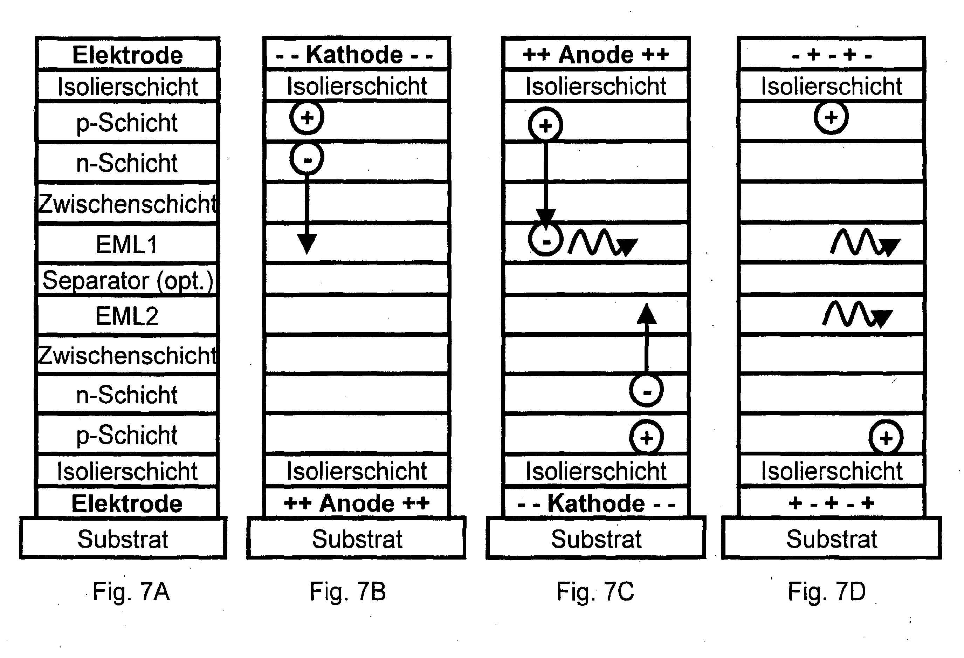

Fig. 7A bis 7D zeigen eine schematische Darstellung eines organischen elektrolumineszenten Bauelementes zum Betrieb mit Wechselspannung, bei dem zwei lichtemittierende Schichten mittels einer bipolaren Trennschicht getrennt sind. Die Trennschicht blockiert einen Austausch von elektrischen Ladungsträgern zwischen den zwei lichtemittierende Schichten. Die Trennschicht ist optional. In einer alternativen Ausführung ohne Trennschicht (nicht dargestellt) kann das Verhältnis von Lichtemissionsanteilen für die zwei lichtemittierenden Schichten mittels einer asymmetrischen Wechselspannung eingestellt werden. Bei einer Ausführung der zwei lichtemittierende Schichten mit unterschiedlichen Emissionsspektren, kann so das Gesamtemissionsspektrum des Bauteils variabel eingestellt werden. Fig. 7B bis 7D zeigen schematisch den Betrieb des organischen elektrolumineszenten Bauelementes aus Fig. 7A beim Anlegen einer elektrischen Wechselspannung.

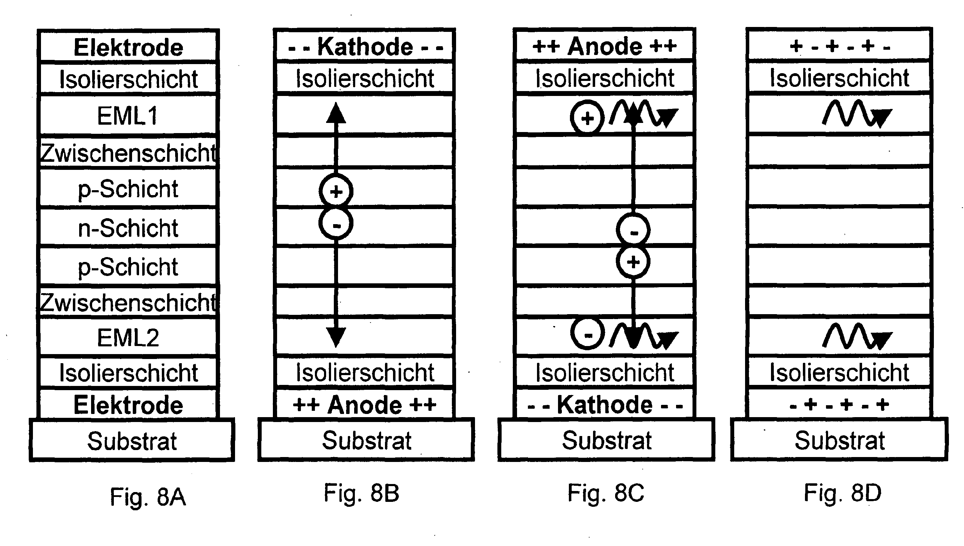

Fig. 8A bis 8D zeigen eine schematische Darstellung eines organischen elektrolumineszenten Bauelementes zum Betrieb mit Wechselspannung, bei dem ein Ladungsträger-Erzeugungsbereich zwischen zwei lichtemittierenden Schichten angeordnet ist. Fig. 8B bis 8D zeigen schematisch den Betrieb des organischen elektrolumineszenten Bauelementes aus Fig. 8A beim Anlegen einer elektrischen Wechselspannung.

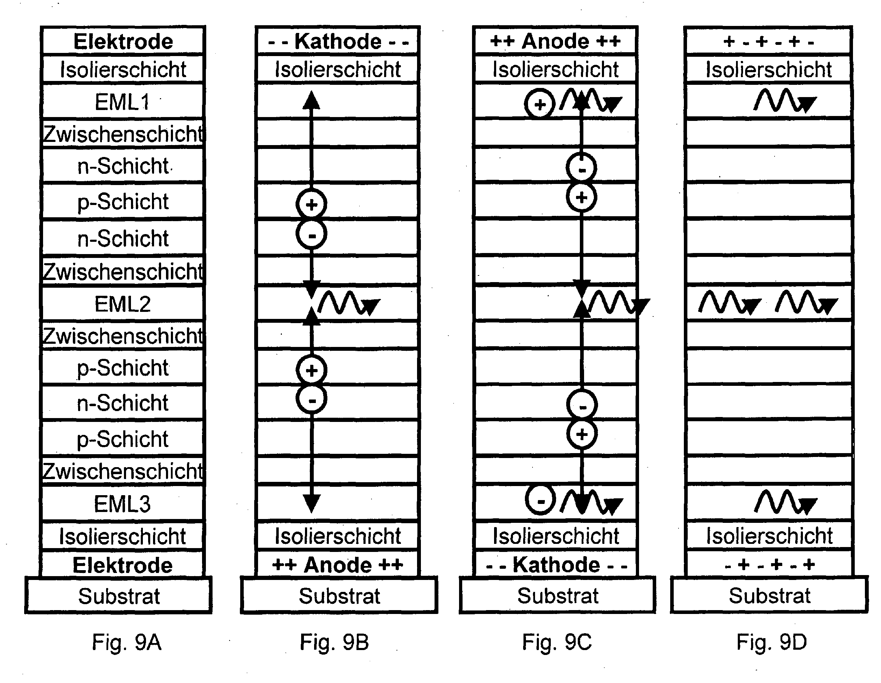

Fig. 9A bis 9D zeigen eine schematische Darstellung eines organischen elektrolumineszenten Bauelementes zum Betrieb mit Wechselspannung, bei dem ein Ladungsträger-Erzeugungsbereich mit einer npn-Schichtstruktur und ein weiterer Ladungsträger-Erzeugungsbereich mit einer pnp-Schichtstruktur vorgesehen sind. Fig. 9B bis 9D zeigen schematisch den Betrieb des organischen elektrolumineszenten Bauelementes aus Fig. 9A beim Anlegen einer elektrischen Wechselspannung.

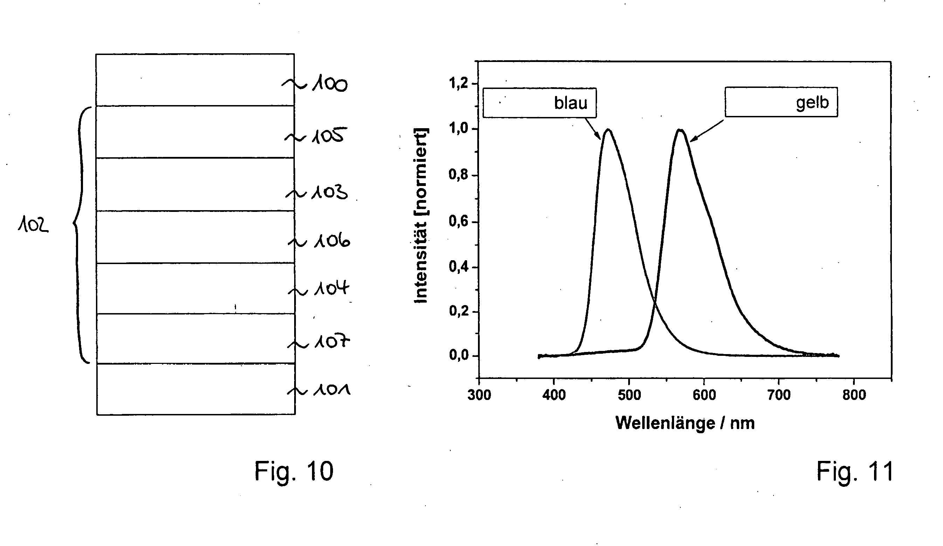

Nachfolgend wird unter Bezugnahme auf die Fig. 10 bis 14 eine Ausführung eines organischen elektrolumineszenten Bauelementes in einer nicht symmetrischen Bauweise näher beschrieben.

Fig. 10 zeigt schematisch einen Schichtaufbau für ein organisches elektrolumineszentes Bauelement in nicht symmetrischer Bauweise. Zwischen Elektroden 100, 101 ist ein Stapel organischer Schichten 102 angeordnet. Der Stapel organischer Schichten 102 umfasst eine erste lichtemittierende Schicht 103, welche mit einem Emittermaterial versehen ist, welches im blauen Bereich des Lichtspektrums emittiert. Eine weitere lichtemittierende Schicht 104 ist mit einem Emittermaterial versehen, welcher im gelben Bereich des Lichtspektrums emittiert. Die Spektren für die beiden Emittermaterialien sind in Fig. 11 gezeigt.

Weiterhin umfasst der Stapel organischer Schichten 102 mehrere organische Schichten 105, 106, 107. Diese Schichten können den oben ausgeführten Gestaltungen für derartige Schichten entsprechend ausgeführt sein.

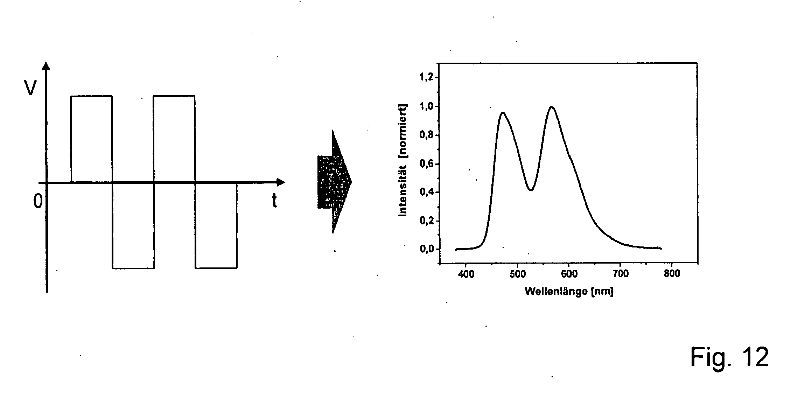

Fig. 12 zeigt graphische Darstellungen für eine symmetrische Wechselspannung und ein Elektrolumineszenzspektrum bei dem Bauelement aus Fig. 10. Es werden symmetrische Spannungsimpulse aufgegeben.

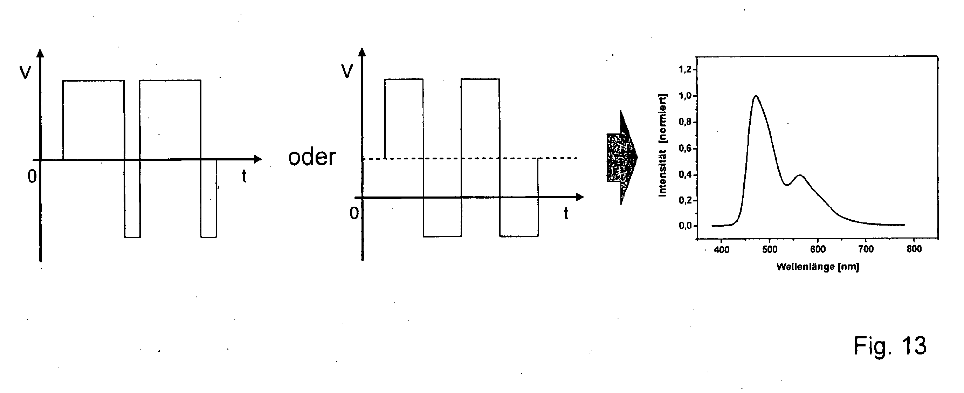

Fig. 13 zeigt graphische Darstellungen für eine nicht symmetrische Wechselspannung und ein sich hieraus ergebendes Elektrolumineszenzspektrum für das Bauelement nach Fig. 10.

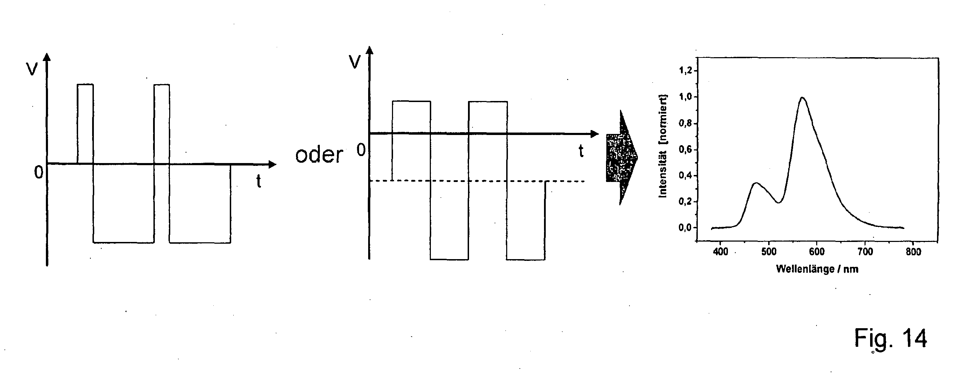

Fig. 14 zeigt graphische Darstellungen für eine nicht symmetrische Wechselspannung und ein sich hieraus ergebendes Elektrolumineszenzspektrum für das Bauelement nach Fig. 10. Bei der Betriebswechselspannung in den Fig. 12 und 13 werden nicht symmetrische Wechselspannungsimpulse auf das Bauelement gegeben, die zu den gezeigten Elektrolumineszenzspektren führen.

Die in den vorangehenden Ausführungsbeispielen erläuterten Ausführungen von Schichtanordnungen, insbesondere betreffend in den Ladungsträger-Erzeugungsbereichen und den lichtemittierenden Schichten können auf beliebige Art und Weise miteinander kombiniert werden, auch wenn dieses für einzelne Kombinationsmöglichkeiten in den Figuren nicht dargestellt ist.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Organisches elektrolumineszentes Bauelement, bei dem zwischen einer Elektrode und einer Gegenelektrode eine von der Elektrode und der Gegenelektrode elektrisch isolierte, organische Schichtanordnung gebildet ist und von der Schichtanordnung eine lichtemittierende Schicht und ein der lichtemittierenden Schicht zugeordneter Ladungsträger-Erzeugungsbereich umfasst sind, wobei der Ladungsträger-Erzeugungsbereich konfiguriert ist, beim Anlegen einer elektrischen Wechselspannung an die Elektrode und die Gegenelektrode positive und negative elektrische Ladungsträger bereitzustellen, dardurch **gekennzeichnet**, dass in dem Ladungsträger-Erzeugungsbereich mittels einer p-dotierten organischen Schicht und einer n-dotierten organischen Schicht, die benachbart zu der p-dotierten organischen Schicht angeordnet ist, ein pn-Schichtübergang gebildet ist.

2. Bauelement nach Anspruch 1, **dadurch gekennzeichnet, dass** die Schichtanordnung von der Elektrode und der Gegenelektrode mittels einer jeweiligen Isolierschicht elektrisch isoliert ist.

3. Bauelement nach Anspruch 2, **dadurch gekennzeichnet, dass** der Ladungsträger-Erzeugungsbereich in Kontakt mit einer der Isolierschichten gebildet ist.

4. Bauelement nach Anspruch 2 oder 3, **dadurch gekennzeichnet, dass** die lichtemittierende Schicht in Kontakt mit einer der Isolierschichten gebildet ist.

5. Bauelement nach mindestens einem der vorangehenden Ansprüche, **dadurch gekenn** - **zeichnet**, dass in dem Ladungsträger-Erzeugungsbereich ein weiterer pn-Schichtübergang gebildet ist, indem:
- der Ladungsträger-Erzeugungsbereich als eine organische npn-Schichtstruktur gebildet ist, bei der benachbart zu der p-dotierten organischen Schicht eine weitere n-dotierte organische Schicht angeordnet ist, oder
- der Ladungsträger-Erzeugungsbereich als eine organische pnp-Schichtstruktur gebildet ist, bei der benachbart zu der n-dotierten organischen Schicht eine weitere p-dotierte organische Schicht angeordnet ist.

6. Bauelement nach mindestens einem der vorangehenden Ansprüche, **dadurch gekennzeichnet, dass** zwischen der lichtemittierenden Schicht und dem Ladungsträger-Erzeugungsbereich eine Zwischenschicht mit bipolaren Ladungsträger-Transporteigenschaften angeordnet ist.

7. Bauelement nach mindestens einem der Ansprüche 1 bis 5, **dadurch gekennzeichnet, dass** die lichtemittierende Schicht in Kontakt mit dem Ladungsträger-Erzeugungsbereich gebildet ist.

8. Bauelement nach mindestens einem der vorangehenden Ansprüche, **dadurch gekennzeichnet, dass** zwischen der lichtemittierenden Schicht und dem Ladungsträger-Erzeugungsbereich eine Zwischenschicht mit bipolaren Transporteigenschaften für die positiven und die negativen elektrischen Ladungsträger angeordnet ist.

9. Bauelement nach mindestens einem der vorangehenden Ansprüche, **dadurch gekennzeichnet, dass** die lichtemittierende Schicht mit mehreren lichtemittierenden Teilschichten gebildet ist.

10. Bauelement nach mindestens einem der vorangehenden Ansprüche, **gekennzeichnet durch** wenigstens eine weitere lichtemittierende Schicht.

11. Bauelement nach Anspruch 10, **dadurch gekennzeichnet, dass** die lichtemittierende Schicht und die wenigstens eine weitere lichtemittierende Schicht benachbart und durch eine bipolare Trennschicht getrennt gebildet sind, die konfiguriert ist, einen Transport der positiven und der negativen elektrischen Ladungsträgern durch die bipolare Trennschicht hindurch zu blockieren.

12. Bauelement nach Anspruch 10, **dadurch gekennzeichnet, dass** der Ladungsträger-Erzeugungsbereich zwischen der lichtemittierende Schicht und der wenigstens einen weiteren lichtemittierenden Schicht angeordnet sind.

13. Bauelement nach mindestens einem der Ansprüche 10 bis 12, **dadurch gekennzeichnet, dass** die lichtemittierende Schicht ein Emittersystem und die wenigstens eine weitere lichtemittierende Schicht ein weiteres Emittersystem umfassen, wobei das Emittersystem und das weitere Emittersystem konfiguriert sind, Licht unterschiedlicher Farbe abzugeben.

14. Bauelement nach mindestens einem der vorangehenden Ansprüche, **gekennzeichnet durch** wenigstens einen weiteren Ladungsträger-Erzeugungsbereich.

15. Bauelement nach Anspruch 14, **dadurch gekennzeichnet, dass** die lichtemittierende Schicht zwischen dem Ladungsträger-Erzeugungsbereich und dem wenigstens einen weiteren Ladungsträger-Erzeugungsbereich angeordnet ist.

16. Bauelement nach Anspruch 10 und einem der Ansprüche 14 und 15, **dadurch gekennzeichnet, dass** in der Schichtanordnung mehrere lichtemittierende Schichten und mehrere Ladungsträger-Erzeugungsbereiche alternierend angeordnet sind.

17. Bauelement nach mindestens einem der vorangehenden Ansprüche, **dadurch gekennzeichnet, dass** die Schichtanordnung wenigstens eine Ladungsträger-Blockschicht aufweist, die konfiguriert ist, eine Transport wenigstens der positiven elektrischen Ladungsträger oder wenigstens der negativen elektrischen Ladungsträger zu blockieren.

18. Bauelement nach mindestens einem der vorangehenden Ansprüche, **dadurch gekennzeichnet, dass** die Schichtanordnung zwischen der Elektrode und der Gegenelektrode mit einer nicht symmetrischen Anordnung der Schichten gebildet ist.

19. Verfahren zum Betreiben eines elektrolumineszenten Bauteils nach Anspruch 18, **dadurch gekennzeichnet, dass** an die Elektrode und die Gegenelektrode eines solchen Bauteils eine nicht symmetrische Wechselspannung angelegt wird

## Claims

1. Organic electronic luminescent component with an arrangement of organic layers formed between an electrode and a counter electrode, wherein said arrangement of organic layers is electrically insulated from the electrode and the counter electrode and comprises a light-emitting layer and a charge carrier generation region allocated to the light-emitting layer, wherein the charge carrier generation region is configured to provide positive and negative charge carriers at an application of an electrical AC voltage to the electrode and the counter electrode **characterised in that** a pn-layer transition is formed in the charge carrier generation region by means of a p-doped organic layer and a n-doped organic layer arranged next to the p-doped organic layer.

2. Component according to claim 1, **characterised in that** the arrangement of layers is electrically insulated from the electrode and the counter electrode by means of a respective insulating layer.

3. Component according to claim 2, **characterised in that** the charge carrier generation region is formed in contact with one of the insulating layers.

4. Component according to claim 2 or 3, **characterised in that** the light-emitting layer is formed in contact with one of the insulating layers.

5. Component according to at least one of the preceding claims, **characterised in that** an additional pn-layer transition is formed in the charge carrier generation region by:
- the charge carrier generation region being formed as an organic npn-layer structure, wherein an additional n-doped organic layer is arranged next to the p-doped organic layer, or
- the charge carrier generation region being formed as an organic pnp-layer structure, wherein an additional p-doped organic layer is arranged next to the n-doped organic layer.

6. Component according to at least one of the preceding claims, **characterised in that** an intermediate layer with bipolar charge carrier transportation properties is arranged between the light-emitting area and the charge carrier generation region.

7. Component according to at least one of the claims 1 to 5, **characterised in that** the light-emitting layer is formed in contact with the charge carrier generation region.

8. Component according to at least one of the preceding claims, **characterised in that** an intermediate layer with bipolar charge carrier transportation properties for the positive and the negative electrical charge carriers is arranged between the light-emitting layer and the charge carrier generation region.

9. Component according to at least one of the preceding claims, **characterised in that** the light-emitting layer is formed of a plurality of light-emitting partial layers.

10. Component according to at least one of the preceding claims, **characterised by** at least one additional light-emitting layer.

11. Component according to claim 10, **characterised in that** the light-emitting layer and the at least one additional light-emitting layer are formed next to each other and are separated by a bipolar separating layer that is configured to block the transportation of the positive and the negative electrical charge carriers through the bipolar separating layer.

12. Component according to claim 10, **characterised in that** the charge carrier generation region is arranged between the light-emitting layer and the at least one additional light-emitting layer.

13. Component according to one of the claims 10 to 12, **characterised in that** the light-emitting layer includes an emitter system and the at least one additional light-emitting layer includes a further emitter system, wherein the emitter system and the further emitter system are configured to emit light of a different colour.

14. Component according to at least one of the preceding claims, **characterised by** at least one additional charge carrier generation region.

15. Component according to claim 14, **characterised in that** the light-emitting layer is arranged between the charge carrier generation region and the at least one additional charge carrier generation region.

16. Component according to claim 10 and one of the claims 14 and 15, **characterised in that** a plurality of light-emitting layers and a plurality of charge carrier generation regions are arranged alternately in the arrangement of layers.

17. Component according to at least one of the preceding claims, **characterised in that** the arrangement of layers has at least one charge carrier blocking layer that is configured to block the transportation of at least the positive electrical charge carriers or of at least the negative electrical charge carriers.

18. Component according to at least one of the preceding claims, **characterised in that** the arrangement of layers is formed between the electrode and the counter electrode with a non-symmetric arrangement of the layers.

19. Method for operating an electronic luminescent component according to claim 18, **characterised in that** a non-symmetric AC voltage is applied at the electrode and the counter electrode of the component.

## Revendications

1. Composant électroluminescent organique, dans lequel entre une électrode et une contre-électrode un dispositif à couches organiques, isolé électriquement de l'électrode et de la contre-électrode est formé et le dispositif à couches comprend une couche émettrice de lumière et une zone de génération de porteur de charge coordonnée à la couche émettrice de lumière, dans lequel la zone de génération de porteur de charge est configurée, afin de fournir un porteur de charge électrique positive et négative lors de l'application d'une tension alternative électrique à l'électrode et à la contre-électrode, **caractérisé en ce que** une transition de couche pn est formée dans la zone de génération de porteur de charge au moyen d'une couche organique dopée p et une couche organique dopée n, qui est disposée de manière à avoisiner la couche organique dopée p.

2. Composant selon la revendication 1, **caractérisé en ce que** le dispositif à couches est isolé électriquement de l'électrode et de la contre-électrode au moyen d'une couche isolante respective.

3. Composant selon la revendication 2, **caractérisé en ce que** la zone de génération de porteur de charge est formée en contact avec une des couches isolantes.

4. Composant selon la revendication 2 ou 3, **caractérisé en ce que** la couche émettrice de lumière est formée en contact avec une des couches isolantes.

5. Composant selon au moins une des revendications précédentes, **caractérisé en ce que** dans la zone de génération de porteur de charge une transition de couche pn supplémentaire est formée, **en ce que** :
- la zone de génération de porteur de charge est formée comme une structure à couches npn organique, dans laquelle une couche organique dopée n supplémentaire est disposée de manière à avoisiner la couche organique dopée p, ou
- la zone de génération de porteur de charge est formée comme une structure à couches pnp organique, dans laquelle une couche organique dopée p supplémentaire est disposée de manière à avoisiner la couche organique dopée n.

6. Composant selon au moins une des revendications précédentes, **caractérisé en ce que** entre la couche émettrice de lumière et la zone de génération de porteur de charge une couche intermédiaire aux propriétés de transport de porteur de charge bipolaires est disposée.

7. Composant selon au moins une des revendications 1 à 5, **caractérisé en ce que** la couche émettrice de lumière est formée en contact avec la zone de génération de porteur de charge.

8. Composant selon au moins une des revendications précédentes, **caractérisé en ce que** entre la couche émettrice de lumière et la zone de génération de porteur de charge une couche intermédiaire aux propriétés de transport bipolaires pour les porteurs de charge électriques positifs et négatifs est disposée.

9. Composant selon au moins une des revendications précédentes, **caractérisé en ce que** la couche émettrice de lumière est formée avec plusieurs couches partielles émettrices de lumière.

10. Composant selon au moins une des revendications précédentes, **caractérisé par** au moins une couche émettrice de lumière supplémentaire.

11. Composant selon la revendication 10, **caractérisé en ce que** la couche émettrice de lumière et la au moins une couche émettrice de lumière supplémentaire sont formées en s'avoisinant et séparées par une couche de séparation bipolaire, qui sont configurées afin de bloquer un transport des porteurs de charge électriques positifs et négatifs à travers la couche de séparation bipolaire.

12. Composant selon la revendication 10, **caractérisé en ce que** la zone de génération de porteur de charge est disposée entre la couche émettrice de lumière et la au moins une couche émettrice de lumière supplémentaire.

13. Composant selon au moins une des revendications 10 à 12, **caractérisé en ce que** la couche émettrice de lumière comprend un système émetteur et la au moins une couche émettrice de lumière comprend un système émetteur supplémentaire, dans lequel le système émetteur et le système émetteur supplémentaire sont configurés afin d'émettre de la lumière de couleur différente.

14. Composant selon au moins une des revendications précédentes, **caractérisé par** au moins une zone de génération de porteur de charge supplémentaire.

15. Composant selon la revendication 14, **caractérisé en ce que** la couche émettrice de lumière est disposée entre la zone de génération de porteur de charge et la au moins une zone de génération de porteur de charge supplémentaire.

16. Composant selon la revendication 10 et une des revendications 14 et 15, **caractérisé en ce que** dans le dispositif à couches plusieurs couches émettrices de lumière et plusieurs zones de génération de porteur de charge sont disposées en alternance.

17. Composant selon au moins une des revendications précédentes, **caractérisé en ce que** le dispositif à couches présente au moins une couche de blocage de porteur de charge, qui est configurée afin de bloquer un transport d'au moins les porteurs de charges électriques positifs ou d'au moins les porteur de charge électriques négatifs.

18. Composant selon au moins une des revendications précédentes, **caractérisé en ce que** le dispositif à couches est formé entre l'électrode et la contre-électrode avec une disposition non symétrique des couches.

19. Procédé de fonctionnement d'un composant électroluminescent selon la revendication 18, **caractérisé en ce que** une tension alternative non symétrique est appliquée sur l'électrode et la contre-électrode d'un tel composant.
